# EUROPÄISCHE PATENTANMELDUNG

(11) **EP 3 799 306 A1**
(43) Veröffentlichungstag der Anmeldung: **31.03.2021**
(21) Anmeldenummer: 19200185.7
(22) Anmeldetag: 27.09.2019
(51) Int. Cl.: H03K 17/082, H02H 3/087, H02H 7/26, H02H 3/10, H02H 3/16, H02H 3/20

(54) **ELEKTRONISCHER SCHUTZSCHALTER**

(71) Anmelder: Siemens Aktiengesellschaft, 80333 München (DE)
(72) Erfinder: Weis, Benno, 91334 Hemhofen (DE)

(57) **Zusammenfassung**

Die Erfindung betrifft einen elektronischer Schutzschalter (1), aufweisend zwei Halbleiterschalter (2) mit jeweils einem Schaltelement (21) und einer zum Schaltelement (21) antiparallel angeordneten Diode (22). Zur Verbesserung des elektronischen Schalters, insbesondere im Hinblick auf die im Betrieb anfallenden Verluste sowie im Hinblick auf eine Fehlerlokalisierung wird vorgeschlagen, dass der elektronische Schalter ferner einen ersten Netzanschluss (3) und einen zweiten Netzanschluss (4) mit jeweils einem positiven Potentialanschluss (31,41) und einem negativen Potentialanschluss (32,42) aufweist, wobei ein erster der Halbleiterschalter (2) halbleiterreihenschaltungsfrei zwischen dem positiven Potentialanschluss (31) des ersten Netzanschlusses (3) und dem positiven Potentialanschluss (41) des zweiten Netzanschlusses (4) angeordnet ist und ein zweiter der Halbleiterschalter (2) halbleiterreihenschaltungsfrei zwischen dem negativen Potentialanschluss (32) des ersten Netzanschlusses (3) und dem negativen Potentialanschluss (42) des zweiten Netzanschlusses (4) angeordnet ist, wobei das Schaltelement (21) der jeweiligen Halbleiterschalter (2) derart angeordnet ist, einen Strom vom ersten Netzanschluss (3) zum zweiten Netzanschluss (4) führen und abschalten zu können. Weiter betrifft die Erfindung ein Energienetz (5), insbesondere ein Gleichspannungsnetz (6), mit einem ersten Energieteilnetz (51) und einem zweiten Energieteilnetz (52), wobei das Energienetz (5) einen derartigen elektronischen Schutzschalter (1) zum Trennen des ersten Energieteilnetzes (51) und des zweiten Energieteilnetzes (52) voneinander aufweist, wobei das erste Energieteilnetz (51) mit dem ersten Netzanschluss (3) verbunden ist und das zweite Energieteilnetz (52) mit dem zweiten Netzanschluss (4) verbunden ist. Ferner betrifft die Erfindung ein Verfahren zum Betreiben eines derartigen Energienetzes (5).

## Beschreibung

Die Erfindung betrifft einen elektronischen Schutzschalter, der zwei Halbleiterschalter mit jeweils einem Schaltelement und einer zum Schaltelement antiparallel angeordneten Diode aufweist. Ferner betrifft die Erfindung ein Energienetz mit einem ersten und einem zweiten Energieteilnetz sowie einem derartigen elektronischen Schutzschalter zum Trennen des ersten Energieteilnetzes vom zweiten Energieteilnetz. Die Erfindung betrifft weiter ein Verfahren zum Betreiben eines derartigen Energienetzes.

Zum Schalten von Strömen werden heutzutage mechanische und elektronische Schalter verwendet. Bei mechanischen Schaltern wird der Kontakt zwischen den zwei Anschlüssen des Schalters auf mechanische Weise hergestellt oder unterbrochen. Diese eignen sich im Besonderen für das Schalten von Wechselspannungsstrom, weil sie günstig herzustellen sind und auch die Schalthandlung aufgrund des Nulldurchgangs des Stromes auf einfache Weise realisiert werden kann. Für das Schalten von Gleichströmen werden mechanische Schalter durchaus komplexer, da ein auftretender Lichtbogen das Schaltverhalten erschwert. Hier kommen heutzutage oftmals elektronische Schalter zum Einsatz. Diese verwenden als schaltendes Element einen oder mehrere abschaltbare Halbleiterschalter. Diese Halbleiterschalter haben den Vorteil, auch ohne Lichtbogen und somit auf einfache Weise einen Gleichstrom schalten zu können. Jedoch weisen diese elektronischen Schalter Durchlassverluste auf. Auf der anderen Seite hat ein elektronischer Schalter den Vorteil in seinem schnellen Schaltvermögen und einer hohen Anzahl von möglichen Schalthandlungen. Dies führt zu einer hohen Lebensdauer des elektronischen Schalters.

Aus der EP 3 379 725 A1 ist ein elektronischer Schalter, auch als Gleichstromschalter bezeichnet, bekannt. Das Dokument beschreibt ein Verfahren zur Steuerung eines derartigen Gleichstromschalters, wobei der Gleichstromschalter einen ersten abschaltbaren Halbleiterschalter und einen zweiten abschaltbaren Halbleiterschalter aufweist, wobei der erste und der zweite abschaltbare Halbleiterschalter derart zwischen einem ersten Anschluss und einem zweiten Anschluss angeordnet sind, dass ein Strom mit einer ersten Polarität durch den ersten abschaltbaren Halbleiterschalter führbar ist und der Strom mit einer gegenüber der ersten Polarität entgegengesetzten Polarität durch den zweiten abschaltbaren Halbleiterschalter führbar ist, wobei in Abhängigkeit eines Strommesswertes einer der abschaltbaren Halbleiterschalter abgeschaltet wird.

Da die verwendeten Halbleiterschalter meistens nur den Strom in eine Stromrichtung abschalten können, werden in einem elektronischen Schalter oftmals mindestens zwei Halbleiterschalter verwendet. Die Halbleiter weisen dabei ein Schaltelement auf, das einen Strom in eine Richtung ein- und ausschalten kann. Der Strom in die andere Richtung wird durch eine parallel zum Schaltelement angeordnete Diode am Schaltelement vorbeigeleitet. Man sagt dazu, dass die Diode antiparallel zum Schaltelement angeordnet ist. Damit ist es durch die Verwendung von zwei in Reihe zwischen den Anschlüssen des elektronischen Schalters angeordneten Halbleiterschaltern möglich, einen Strom durch den elektronischen Schalter in beide Stromrichtungen zu schalten, insbesondere abzuschalten. Diese Anordnung der Halbleiterschalter erfolgt antiseriell zueinander. Das bedeutet, dass ein erster Halbleiterschalter einen Strom der ersten Polarität, also in einer Stromrichtung, abschalten kann und der zweite Schalter einen Strom mit entgegengesetzter Polarität, also entgegengesetzter Stromrichtung, abschalten kann.

Für die Verwendung in einem Gleichspannungsnetz, bei dem eine Last, die über Leitungen oder Stromschienen, auch allgemein als Zuführungen oder Zuleitungen bezeichnet, mit einer Gleichspannungsquelle verbunden ist, ist es hinreichend, nur eine der beiden Zuführungen mit einem elektronischen Schalter zu versehen. Mit diesem elektronischen Schalter kann die Energiezufuhr zwischen Energieversorgungsnetz und Last zuverlässig unterbrochen werden. Das liegt daran, dass über die beiden Zuführungen, zwischen denen die Gleichspannung anliegt, immer ein Strom von gleicher Höhe, aber unterschiedlicher Polarität fließt. Insbesondere in isolierten Gleichspannungsnetzen wird nur in eine Zuführung der elektronische Schalter angeordnet, um somit die Kosten und die Verluste gering zu halten. Will man jedoch einen Erdschluss sicher erkennen und beherrschen, sowie lokalisieren, so ordnet man in beiden Zuführungen einen entsprechenden elektronischen Schalter an. Durch die Messung der Spannung über den beiden elektronischen Schaltern in den jeweiligen Zuführungen können hinreichend Informationen gewonnen werden, mit denen sich ein Erdschluss erkennen und lokalisieren lässt.

Als Energienetz wird ein Netz von Energiequellen und/oder elektrischen Verbrauchern verstanden, die miteinander verbunden sind. Diese können in einzelne Energieteilnetze unterteilt sein. Das Energienetz weist dabei eine Gleich- oder Wechselspannung zur Übertragung von elektrischer Energie auf.

Der Erfindung liegt die Aufgabe zugrunde, einen elektronischen Schalter für ein Gleichspannungsnetz zu verbessern.

Diese Aufgabe wird durch einen elektronischen Schutzschalter, aufweisend zwei Halbleiterschalter mit jeweils einem Schaltelement und einer zum Schaltelement antiparallel angeordneten Diode und ferner aufweisend einen ersten Netzanschluss und einen zweiten Netzanschluss mit jeweils einem positiven Potentialanschluss und einem negativen Potentialanschluss, gelöst, wobei ein erster der Halbleiterschalter halbleiterreihenschaltungsfrei zwischen dem positiven Potentialanschluss des ersten Netzanschlusses und dem positiven Potentialanschluss des zweiten Netzanschlusses angeordnet ist und ein zweiter der Halbleiterschalter halbleiterreihenschaltungsfrei zwischen dem negativen Potentialanschluss des ersten Netzanschlusses und dem negativen Potentialanschluss des zweiten Netzanschlusses angeordnet ist, wobei das Schaltelement der jeweiligen Halbleiterschalter derart angeordnet ist, einen Strom vom ersten Netzanschluss zum zweiten Netzanschluss führen und abschalten zu können. Ferner wird diese Aufgabe durch ein Energienetz, insbesondere ein Gleichspannungsnetz, mit einem ersten Energieteilnetz und einem zweiten Energieteilnetz, wobei das Energienetz einen derartigen elektronischen Schutzschalter zum Trennen des ersten Energieteilnetzes und des zweiten Energieteilnetzes voneinander aufweist, wobei das erste Energieteilnetz mit dem ersten Netzanschluss verbunden ist und das zweite Energieteilnetz mit dem zweiten Netzanschluss verbunden ist. Ferner wird diese Aufgabe durch ein Verfahren zum Betreiben eines derartigen Energienetzes gelöst, wobei bei Auftreten eines Erdschlusses im Energienetz der elektronische Schutzschalter geöffnet wird.

Weitere vorteilhafte Ausgestaltungen der Erfindung sind in den abhängigen Ansprüchen angegeben.

Der Erfindung liegt die Erkenntnis zugrunde, dass sich ein elektronischer Schalter, der sich zum Schutz vor Beschädigungen bei Auftreten eines Fehlers, insbesondere bei Auftreten eines Erdschlusses, in einem Energienetz, insbesondere in einem Gleichspannungsnetz, eignet, durch eine gegenüber einem bekannten elektronischen Schalter veränderte Anordnung der Halbleiterschalter verbessern lässt. Dazu werden die beiden antiseriell vorhandenen Halbleiterschalter eines bekannten elektronischen Schalters nun in den unterschiedlichen Zuführungen zwischen einem Energieversorgungsnetz, einer Energiequelle oder allgemein einem erstes Energieteilnetz und einer Last, Verbraucher oder allgemein einem zweiten Energieteilnetz verteilt angeordnet. Dadurch weisen dann die Verbindungen zwischen dem ersten Netzanschluss und dem zweiten Netzanschluss keine Reihenschaltung von Halbleiterschaltern mehr auf. Da keine Reihenschaltung von Halbleitern mehr zwischen dem ersten und dem zweiten Netzanschluss vorhanden ist, wird diese Anordnung auch als halbleiterreihenschaltungsfrei bezeichnet. Die beiden Energieteilnetze können dabei jeweils beliebig viele Energiequellen und/oder Lasten, wie beispielsweise elektrische Verbraucher, aufweisen.

Der Halbleiterschalter weist ein Schaltelement und eine Diode auf. Dabei ist die Dioden antiparallel zum Schaltelement angeordnet. Während das Schaltelement einen Strom in eine Stromrichtung führen und leiten kann, kann die Dioden nur einen Strom in entgegengesetzter Richtung führen, aber nicht schalten.

Da der elektronische Schalter zum Schutz vor einem Fehler oder den Auswirkungen des Fehlers im Energienetz vorgesehen ist, wird er auch als elektronischer Schutzschalter bezeichnet. Bei der antiparallelen Anordnung ist der Halbleiterschalter derart angeordnet, einen Strom vom ersten Netzanschluss zum zweiten Netzanschluss führen und abschalten zu können und die Diode der jeweiligen Halbleiterschalter derart angeordnet ist, einen Strom vom zweiten Netzanschluss zum ersten Netzanschluss führen zu können. Dabei ist das Schaltelement der jeweiligen Halbleiterschalter derart zwischen dem ersten und zweiten Netzanschluss angeordnet, dass ein Strom in den einzelnen Potentialanschlüssen, vom ersten zum zweiten Netzanschluss durch das Schaltelement fließt und ein Strom in entgegengesetzter Richtung, also vom zweiten zum ersten Netzanschluss durch die antiparallel zum Schaltelement angeordneten Diode fließt. Alternativ ist es auch möglich, das Schaltelement der jeweiligen Halbleiterschalter derart zwischen dem ersten und zweiten Netzanschluss angeordnet, dass ein Strom in den einzelnen Potentialanschlüssen, vom zweiten zum ersten Netzanschluss durch das Schaltelement fließt und ein Strom in entgegengesetzter Richtung, also vom ersten zum zweiten Netzanschluss durch die antiparallel zum Schaltelement angeordneten Diode fließt.

Durch die Anordnung in unterschiedlichen Zuführungen ist es möglich, die Verbindung zwischen dem Energieversorgungsnetz und der Last und damit auch den Energieaustausch zwischen Energieversorgungsnetz und Last zu trennen, auch wenn nur ein Schaltelement in der jeweiligen Zuführung vorhanden ist, da durch die Zuführungen jeweils ein Strom von gleicher Größe, jedoch in unterschiedlicher Richtung fließt. Die Summe der Ströme in einer Richtung ist gleich der Summe der Ströme in die andere Richtung, die sich auf die unterschiedlichen Zuführungen verteilen. Die Halbleiter sind dabei so in den jeweiligen Zuführungen angeordnet, dass sie diesen Strom in eine Richtung, insbesondere vom ersten Netzanschluss zum zweiten Netzanschluss, abschalten können. Damit kann die Verbindung und der Energieaustausch zwischen den Energieteilnetzen, beispielsweise einer Energiequelle und einer Last, unterbrochen werden. Der elektronische Schutzschalter hat somit insgesamt mindestens vier Anschlüsse, mindestens zwei als ersten Netzanschluss, zur Verbindung mit einem ersten Energieteilnetz, wie beispielsweise einer Energiequelle, und mindestens zwei weitere Anschlüsse als zweiten Netzanschluss zur Verbindung mit einem zweiten Energieteilnetz, beispielsweise einer Last.

In einem Gleichspannungsnetz weist der elektronische Schutzschalter vorteilhafterweise genau zwei Potentialanschlüsse als ersten Netzanschluss und genau zwei Potentialanschlüsse als zweiten Netzanschluss auf, da für diese Anwendungen zwischen Energiequelle und Last genau zwei Zuführungen vorhanden sind, zwischen denen die Versorgungsspannung, die Gleichspannung, anliegt. Die beiden Potentialanschlüsse der jeweiligen Netzanschlüsse sind dann dafür vorgesehen, bei diesem Gleichspannungsnetz zum einen mit dem positiven Potential der Last bzw. der Energiequelle und mit dem negativen Potential der Energiequelle bzw. der Last verbunden zu werden. Allgemein kann es sich statt einer Energiequelle und einer Last um ein erster Energieteilnetz, also ein erstes Gleichspannungsteilnetz, und um ein zweites Energieteilnetz, also ein zweites Gleichspannungsteilnetz, handeln. Daher werden diese Potentialanschlüsse jeweils auch als positiver Potentialanschluss bzw. negativer Potentialanschluss bezeichnet. Der Strom durch die beiden Zuführungen ist im fehlerfreien Betrieb betraglich gleich groß, unterscheidet sich allerdings im Vorzeichen. Mit anderen Worten hat der Strom eine unterschiedliche Polarität in den beiden Zuführungen. Es handelt sich dabei um den Hinstrom und den Rückstrom zwischen der Energiequelle und der Last.

Allgemein eignet sich ein derartiger elektronsicher Schutzschalter ebenso für die Verwendung in einem einphasigen Wechselspannungsnetz. Auch dieses hat zwei Zuführungen, auf die die Halbleiterschalter verteilt werden können. Der elektronische Schutzschalter hat dann auch zwei Potentialanschlüsse pro Netzanschluss, wobei dann beispielsweise der positive Potentialanschluss mit der Phase und der negative Netzanschluss mit dem Neutralleiter verbunden ist.

Auch die Verwendung in einem dreiphasigen Energienetz ist möglich. Je nach Ausgestaltung weist dieses dann drei oder vier Zuführungen (drei Phasen und ggf. ein Neutralleiter) auf. Der elektronische Schutzschalter für ein solches Netz weist dann drei oder vier Potentialanschlüsse auf. Auch hier sind die Schaltelemente alle so zwischen den einzelnen Potentialanschlüssen des ersten und zweiten Netzanschlusses angeordnet, einen Strom vom ersten Netzanschluss zum zweiten Netzanschluss führen und abschalten zu können. Auch hier sind die Halbleiter halbleiterreihenschaltungsfrei, also ohne Verwendung einer Reihenschaltung zweier Halbleiterschalter, zwischen dem ersten und dem zweiten Netzanschluss angeordnet. Die Dioden des Halbleiterschalters befinden sich auch in dieser Anordnung entsprechend antiparallel zum Schaltelement.

Um einen Fehler wie einen Erdschluss sicher lokalisieren zu können, ist es nicht möglich, nur in einer Zuführung einen elektronischen Schalter anzuordnen. Bisher hat man daher für diesen Fall zwei elektronische Schalter mit jeweils zwei Halbleitern für die Verbindung des Energieversorgungsnetzes mit der Last verwendet. In diesem Fall fallen jedoch durch die Durchlassverluste der einzelnen Schalter insgesamt viermal Durchlassverluste über die jeweiligen Halbleiterleiter an. Durch den vorgeschlagenen elektronischen Schutzschalter mit insgesamt nur zwei Halbleitern können die Durchlassverluste halbiert werden. Ebenso ist er deutlich günstiger herstellbar, da nur die Hälfte der Halbleiter benötigt werden und dadurch teure Halbleiterschalter eingespart werden können.

Bei einer vorteilhaften Ausgestaltung der Erfindung weist der elektronische Schutzschalter jeweils eine Spannungserfassung zur Messung einer Spannung zwischen dem positiven Potentialanschluss des ersten Netzanschlusses und einem Erdpotential und/oder einer Spannung zwischen dem negativen Potentialanschluss des ersten Netzanschlusses und dem Erdpotential und/oder einer Spannung zwischen dem positiven Potentialanschluss des zweiten Netzanschlusses und dem Erdpotential und/oder einer Spannung zwischen dem negativen Potentialanschluss des zweiten Netzanschlusses und dem Erdpotential auf.

Im Vergleich zu einem elektronischen Schalter, der sich nur in einer Zuführung befindet, hat der elektronische Schutzschalter mit jeweils einem Halbleiter in den jeweiligen Zuführungen den Vorteil, auch über den Zustand der zweiten Zuführung Informationen zu gewinnen können. In einem Gleichspannungsnetz sind die beiden Halbleiterschalter dabei auf die beiden Zuführungen verteilt. Dabei können zwischen dem ersten Netzanschluss und dem Erdpotential und dem zweiten Netzanschluss und dem Erdpotential mittels der jeweiligen Spannungserfassung aufgrund der Durchlassspannung über dem entsprechenden Halbleiterschalter oder bei einem Stromfluss über die Dioden die Durchlassspannung der Dioden unterschiedliche Werte gemessen werden. Diese Information ist hilfreich bei der Erkennung und Lokalisierung von Fehlern wie beispielsweise Erdschlüssen im Gleichspannungsnetz. Mit anderen Worten kann durch die Aufteilung der Halbleiter des elektronischen Schalters von einer Zuführung auf die beiden Zuführungen ein Freiheitsgrad in der Messung gewonnen werden, aus dem sich Informationen zu Fehlern, insbesondere Erdschlüsse im Gleichspannungsnetz bestimmen lassen. Im Gegensatz zu einer Anordnung, in der sich nur ein elektronischer Schalter in einer der beiden Zuleitungen befindet, kann bei Auftreten eines Stroms durch den Halbleiterschalter oder die Diode in der entsprechend anderen Zuleitung anhand der aufgrund der Durchlassspannung unterschiedlichen Potentiale der beiden Anschlüsse des Halbleiterschalters gegenüber dem Erdpotential ein Erdschluss zuverlässig lokalisiert werden. Gleichzeitig weist der elektronische Schutzschalter keine höheren Verluste auf, da er für die Anwendung in einem Gleichspannungsnetz durch genau zwei Halbleiterschaltern im zu schaltenden Strompfad aufgebaut ist. Da im Erdschlussfall nur genau ein Potential eines Halbleiteranschlusses gleich dem Erdpotential ist, kann aus dieser Information dieser Anschluss als Ort des Erdschlusses erkannt werden.

Durch die Lokalisierung des Erdschlusses ist es möglich, diese Information an eine übergeordnete oder weitere Steuer- oder Schutzeinrichtung zu übermitteln, die dann den Bereich, in dem der Fehler vorliegt, sicher abschaltet. Somit kann auch durch den elektronischen Schutzschalter ein sicherer Betrieb ermöglicht werden. Die Abschaltung des betroffenen Bereiches kann dann beispielsweise mittels seines zugehörigen Halbleiterschalters oder eines mechanischen Schalters geschehen, der im Normalbetrieb nahezu keine Verluste erzeugt und nur auf eine geringe Anzahl von Schalthandlungen ausgelegt zu werden braucht.

Im Folgenden wird die Erfindung anhand der in den Figuren dargestellten Ausführungsbeispielen näher beschrieben und erläutert. Es zeigen:
- FIG 1: eine Energieversorgung einer Last über einen bekannten elektronischen Schalter,
- FIG 2: einen elektronischen Schutzschalter und
- FIG 3: ein Gleichspannungssystem.

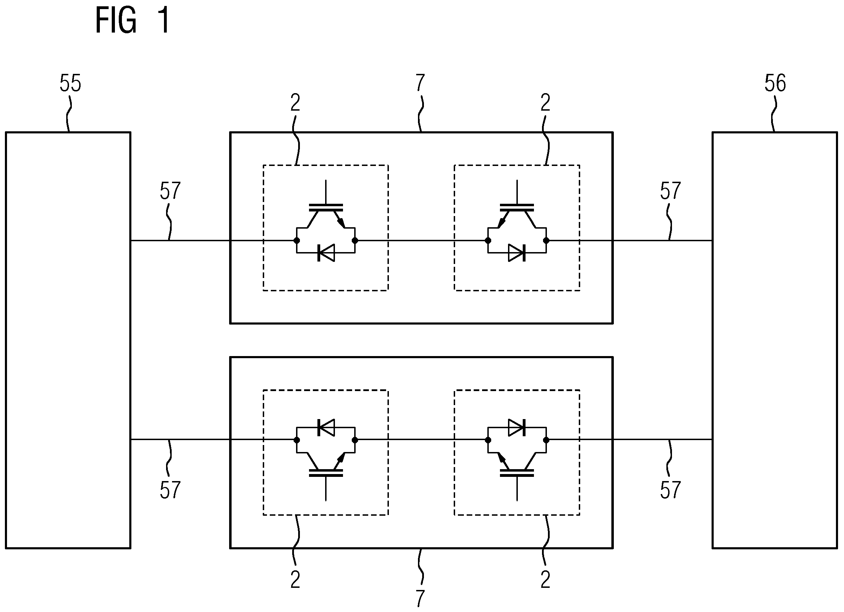

Die FIG 1 zeigt eine bekannte Anordnung, bei der eine Energiequelle 55 über zwei bekannte elektronische Schalter 7 mit einer Last 56 verbunden ist. Die elektronischen Schalter 7 sind dabei in den einzelnen Zuführungen 57 angeordnet, welche die Energiequelle 55 mit der Last 56 elektrisch verbinden. Dabei handelt es sich beispielsweise um ein Gleichspannungsnetz, bei dem Energiequelle 55 und Last 56 über zwei Zuführungen 57 miteinander verbunden sind, und bei dem zwischen den beiden Zuführungen 57 eine Gleichspannung anliegt. Um die Last 56 vom Energieversorgungsnetz 55 trennen zu können, ist in jeder der beiden Zuführungen 57 jeweils ein elektronischer Schalter 7 vorhanden. Durch den elektronische Schalter 7 in beiden Zuführungen 57 kann ein Strom in nur einer der beiden Zuführungen 57, wie er beispielsweise in einem Erdschluss auftreten kann, zuverlässig abgeschaltet werden.

Der elektronische Schalter 7 weist eine Reihenschaltung zweier Halbleiterschalter 2 auf, die in einer Reihenschaltung angeordnet sind. Die Halbleiterschalter 2 weisen dabei ein Schaltelement 21 auf, das einen Strom in eine Richtung führen und abschalten kann. Parallel zu diesem Schaltelement 21 ist Diode 22 angeordnet, die einen Strom in die entgegengesetzte Richtung führen jedoch nicht abschalten kann. Die Diode 22 ist somit antiparallel zum Schaltelement 21 angeordnet. Die Halbleiterschalter 2 sind dabei antiseriell angeordnet. Antiseriell bedeutet, dass durch den elektronischen Schalter 7 mittels einem der beiden Halbleiterschalter 2 ein Strom in einer Richtung abgeschaltet werden kann und ein Strom in entgegengesetzter Richtung durch den anderen der beiden Halbleiterschalter 2 abgeschaltet werden kann.

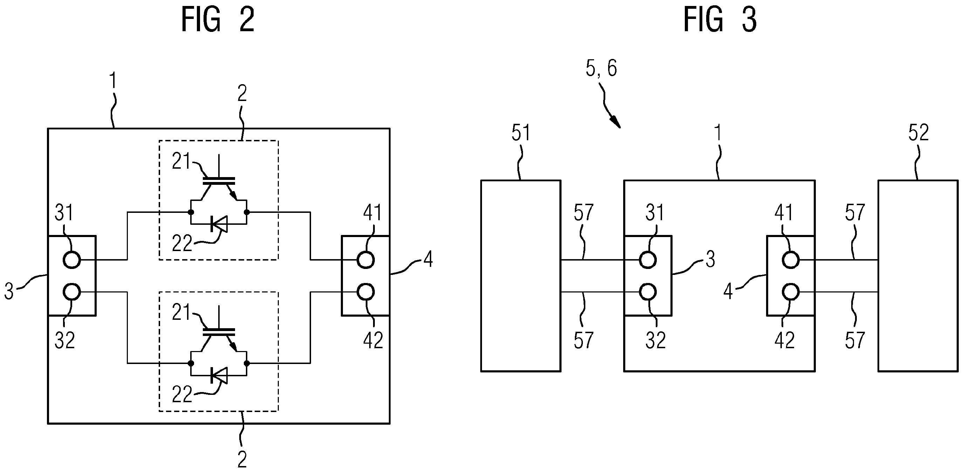

Die FIG 2 zeigt einen elektronischen Schutzschalter 1. Dieser weist zwei Halbleiterschalter 2 auf, bei denen jeweils die Diode 22 antiparallel zu dem Schaltelement 21 angeordnet ist. Im Gegensatz zu dem bereits bekannten elektronischen Schalter 7 weist dieser insgesamt vier Phasenanschlüsse 31, 32, 41, 42 auf. Zwei dieser Phasenanschlüsse 31, 32 bilden den ersten Netzanschluss 3, weitere zwei dieser Phasenanschlüsse 41, 42 bilden den zweiten Netzanschluss 4. Sowohl am ersten wie auch am zweiten Netzanschluss 3, 4 werden die beiden Zuführungen verbunden, an denen bei der Verwendung in einem Gleichspannungsnetz 6 die Gleichspannung anliegt. Somit weisen die Phasenanschlüsse 31, 32, 41, 42 am ersten Netzanschluss 3 und am zweiten Netzanschluss jeweils ein positives Potential und ein negatives Potential dieser Gleichspannung auf. Um die Anschlüsse der Netzanschlüsse jeweils voneinander unterscheiden zu können werden diese als positiver Potentialanschluss 31, 41 und als negativer Potentialanschluss 32, 42 bezeichnet. Diese Bezeichnung wird im Folgenden auch beibehalten, wenn der elektronische Schutzschalter in einem Wechselspannungsnetz eingesetzt wird und es sich hierbei um einen Phasenanschluss und einen Neutralleiteranschluss handelt.

Die Halbleiterschalter 2 sind derart in den Zuführungen angeordnet, einen Energiefluss zwischen erstem Netzanschluss 3 und zweitem Netzanschluss 4 zu unterbrechen. Diese Unterbrechung kann für beide Energieflussrichtungen sichergestellt werden, da zwischen dem positiven Potentialanschluss 31 des ersten Netzanschlusses und dem positiven Potentialanschluss 41 des zweiten Netzanschlusses 4 der gleiche Strom fließt wie zwischen dem negativen Potentialanschluss 32 des ersten Netzanschlusses 3 und dem negativen Potentialanschluss 42 des zweiten Netzanschlusses 4. Die Ströme unterscheiden sich jeweils nur in ihrer Richtung. Es handelt sich dabei um einen Hinstrom und einem Rückstrom von Energiequelle zur Last. Um den Energiefluss unabhängig von der Energieflussrichtung unterbrechen zu können, fließt der Strom einmal durch das Schaltelement 21 und einmal durch die Diode 22. Somit kann der Strom unabhängig von der Energieflussrichtung unterbrochen werden.

Im Gegensatz zu der Verwendung zweier elektronischer Schalter 7 nach FIG 1 fallen bei dem elektronischen Schutzschalter im gesamten Stromkreis für Hinstrom und Rückstrom nur zweimal die Durchlassverluste der Halbleiterschalter 2 an, während sie bei der Verwendung zweier elektronischer Schalter 7 viermal anfallen. Somit kann der elektronische Schutzschalter 1 die Verluste gegenüber der bekannten Lösung halbieren.

Die FIG 3 zeigt ein Energienetz 5. Durch die zwei Zuführungen zwischen kann es sich hierbei beispielsweise um eine Gleichspannungsnetz 6 handeln. Alternativ ist auch die Ausbildung als Wechselspannungsnetz möglich. Dieses Energienetz 5 weist im Allgemeinen ein erstes Energieteilnetz 51 und ein zweites Energieteilnetz 52 auf. Diese sind über zwei Zuführungen 57 miteinander verbunden, wobei in diese Zuführungen 57 der elektronische Schutzschalter 1 eingebracht ist, um die beiden Teilnetze voneinander trennen oder miteinander verbinden zu können. Die Energieteilnetzen 51,52 können dabei eine oder mehrere nicht näher dargestellte Energiequellen und/oder eine oder mehrere nicht näher dargestellte Lasten wie elektrische Verbraucher aufweisen. Dabei ist es möglich, dass die Energieteilnetze eine Kombination von Energiequellen und Lasten aufweisen. Im einfachen Fall handelt es sich bei dem einen Energieteilnetz 51 um eine Energiequelle, die als Gleichspannungsquelle ausgebildet ist, und bei dem zweiten Energieteilnetz um eine Last, die mit einer Gleichspannung versorgt wird. Mit Hilfe des elektronischen Schutzschalters 1 lässt sich ein Energiefluss zwischen den beiden Teilnetzen unabhängig von der Energieflussrichtung unterbrechen. Darüber hinaus lässt sich mit dieser Anordnung ein auftretender Fehler, insbesondere ein Erdschluss, erkennen und lokalisieren, indem die an den jeweiligen Potentialen 31, 32, 41, 42 gegenüber dem Erdpotential anliegende Spannung gemessen und ausgewertet wird. Dies ist insbesondere für die Anwendung in einem isoliert aufgebauten Gleichspannungsnetz von Vorteil.

Zusammenfassend betrifft die Erfindung einen elektronischer Schutzschalter, aufweisend zwei Halbleiterschalter mit jeweils einem Schaltelement und einer zum Schaltelement antiparallel angeordneten Diode. Zur Verbesserung des elektronischen Schalters, insbesondere im Hinblick auf die im Betrieb anfallenden Verluste sowie im Hinblick auf eine Fehlerlokalisierung wird vorgeschlagen, dass der elektronische Schalter ferner einen ersten Netzanschluss und einen zweiten Netzanschluss mit jeweils einem positiven Potentialanschluss und einem negativen Potentialanschluss aufweist, wobei ein erster der Halbleiterschalter halbleiterreihenschaltungsfrei zwischen dem positiven Potentialanschluss des ersten Netzanschlusses und dem positiven Potentialanschluss des zweiten Netzanschlusses angeordnet ist und ein zweiter der Halbleiterschalter halbleiterreihenschaltungsfrei zwischen dem negativen Potentialanschluss des ersten Netzanschlusses und dem negativen Potentialanschluss des zweiten Netzanschlusses angeordnet ist, wobei das Schaltelement der jeweiligen Halbleiterschalter derart angeordnet ist, einen Strom vom ersten Netzanschluss zum zweiten Netzanschluss führen und abschalten zu können. Weiter betrifft die Erfindung ein Energienetz, insbesondere ein Gleichspannungsnetz, mit einem ersten Energieteilnetz und einem zweiten Energieteilnetz, wobei das Energienetz einen derartigen elektronischen Schutzschalter zum Trennen des ersten Energieteilnetzes und des zweiten Energieteilnetzes voneinander aufweist, wobei das erste Energieteilnetz mit dem ersten Netzanschluss verbunden ist und das zweite Energieteilnetz mit dem zweiten Netzanschluss verbunden ist. Ferner betrifft die Erfindung ein Verfahren zum Betreiben eines derartigen Energienetzes.

## Patentansprüche

1. Elektronischer Schutzschalter (1), aufweisend
- zwei Halbleiterschalter (2) mit jeweils einem Schaltelement (21) und einer zum Schaltelement (21) antiparallel angeordneten Diode (22) und
- einen ersten Netzanschluss (3) und einen zweiten Netzanschluss (4) mit jeweils einem positiven Potentialanschluss (31,41) und einem negativen Potentialanschluss (32,42),
wobei ein erster der Halbleiterschalter (2) halbleiterreihenschaltungsfrei zwischen dem positiven Potentialanschluss (31) des ersten Netzanschlusses (3) und dem positiven Potentialanschluss (41) des zweiten Netzanschlusses (4) angeordnet ist und ein zweiter der Halbleiterschalter (2) halbleiterreihenschaltungsfrei zwischen dem negativen Potentialanschluss (32) des ersten Netzanschlusses (3) und dem negativen Potentialanschluss (42) des zweiten Netzanschlusses (4) angeordnet ist, wobei das Schaltelement (21) der jeweiligen Halbleiterschalter (2) derart angeordnet ist, einen Strom vom ersten Netzanschluss (3) zum zweiten Netzanschluss (4) führen und abschalten zu können.

2. Elektronischer Schutzschalter (1) nach Anspruch 1, wobei der elektronische Schutzschalter (1) genau zwei Halbleiterschalter (2) für das Schalten eines Stroms zwischen den Netzanschlüssen (3,4) in einem Gleichspannungsnetz aufweist.

3. Elektronischer Schutzschalter (1) nach einem der Ansprüche 1 oder 2, wobei der elektronische Schutzschalter (1) jeweils eine Spannungserfassung zur Messung einer Spannung zwischen dem positiven Potentialanschluss (31) des ersten Netzanschlusses (3) und einem Erdpotential und/oder einer Spannung zwischen dem negativen Potentialanschluss (32) des ersten Netzanschlusses (3) und dem Erdpotential und/oder einer Spannung zwischen dem positiven Potentialanschluss (41) des zweiten Netzanschlusses (4) und dem Erdpotential und/oder einer Spannung zwischen dem negativen Potentialanschluss (42) des zweiten Netzanschlusses (4) und dem Erdpotential aufweist.

4. Energienetz (5), insbesondere ein Gleichspannungsnetz (6), mit einem ersten Energieteilnetz (51) und einem zweiten Energieteilnetz (52), wobei das Energienetz (5) einen elektronischen Schutzschalter (1) nach einem der Ansprüche 1 bis 3 zum Trennen des ersten Energieteilnetzes (51) und des zweiten Energieteilnetzes (52) voneinander aufweist, wobei das erste Energieteilnetz (51) mit dem ersten Netzanschluss (3) verbunden ist und das zweite Energieteilnetz (52) mit dem zweiten Netzanschluss (4) verbunden ist.

5. Verfahren zum Betreiben eines Energienetzes (5) nach Anspruch 4, wobei bei Auftreten eines Erdschlusses im Energienetz (5) der elektronische Schutzschalter (1) geöffnet wird.

6. Verfahren nach Anspruch 5, wobei aus der Messung einer Spannung zwischen dem positiven Potentialanschluss (31) des ersten Netzanschlusses (3) und einem Erdpotential und/oder einer Spannung zwischen dem negativen Potentialanschluss (32) des ersten Netzanschlusses (3) und dem Erdpotential und/oder einer Spannung zwischen dem positiven Potentialanschluss (41) des zweiten Netzanschlusses (4) und dem Erdpotential und/oder einer Spannung zwischen dem negativen Potentialanschluss (42) des zweiten Netzanschlusses (4) und dem Erdpotential der Ort des Fehlers ermittelt wird.
